# EUROPÄISCHE PATENTANMELDUNG

(11) **EP 1 336 667 A1**
(43) Veröffentlichungstag der Anmeldung: **20.08.2003**
(21) Anmeldenummer: 02028442.8
(22) Anmeldetag: 19.12.2002
(51) Int. Cl.: C23C 16/04, B05D 7/24

(54) **Vorrichtung zum Beschichten von Hohlkörpern**

(30) Priorität: 18.02.2002 DE 10206822
(71) Anmelder: KHS Maschinen- und Anlagenbau Aktiengesellschaft, 44143 Dortmund (DE)
(72) Erfinder: Hellige, Ullrich, 44267 Dortmund (DE)

(57) **Zusammenfassung**

Vorrichtung zur gleichzeitigen Plasma-Beschichtung der inneren Oberflächen mehrerer Behälter, z.B. PET-Flaschen, dabei ist vorgesehen, dass die zu beschichtenden Flaschen von einer Beladevorrichtung (3) aus einem Einlaufmagazin (2) entnommen und auf einen höhenverstellbaren, mit Flaschendrehantrieben (6) und Höhenausgleichern ausgestatteten Transportwagen (4) abgesetzt werden, und dass dieser Transportwagen (4) die Behälter in eine Behandlungsposition transportiert und diese nach der Behandlung in eine weitere Position transportiert, in welcher die Behälter durch eine Entladevorrichtung (9) von dem Transportwagen (4) entnommen und auf ein Auslaufmagazin (10) abgesetzt werden.

## Beschreibung

Die Erfindung betrifft eine Maschine zur gleichzeitigen Beschichtung der inneren Oberflächen mehrerer Hohlkörper, die auf einer verfahrbaren Transportvorrichtung gehalten sind.

Um Kunststoff-Hohlkörper, zum Beispiel PET-Flaschen, gegen niedermolekulare Gase, wie zum Beispiel Sauerstoff, undurchlässig zu machen, ist es bekannt, die PET-Flaschen innen mit einer Beschichtung, zum Beispiel einer SiOx Schicht, zu versehen, weil diese gute Barriereeigenschaften gegen derartige Gase hat. Für diese Innenbeschichtung wird ein Prozessgasgemisch über ein Gaszuführungsrohr in das Innere der PET-Flasche, welches vorher evakuiert worden ist, eingeblasen. Mit Hilfe von Mikrowellenenergie kann man dieses Plasma zünden und die inneren Oberflächen der Flasche beschichten.

Im Labor und auch schon in größerem Maßstab hat man PET-Flaschen über den Einsatz von Mikrowellenenergie beschichtet. Es ist auch schon bekannt, eine Mehrzahl von Hohlkörpern gleichzeitig innen zu beschichten, wobei man eine Maschine ähnlich der eingangs bezeichneten Art verwendet. Bei dieser bekannten Maschine werden Kunststoffflaschen mit ihrer Öffnung nach unten so auf eine ebene Hohlkörperträgerplatte aufgesetzt, dass der jeweilige Flaschenhals von der Trägerplatte gehalten wird. Die Trägerplatte selbst steht in der Waagerechten wie ein Tablett, und eine Reihe von Flaschen erstreckt sich vertikal derart mit ihrem Boden nach oben, dass von unten ein vertikal hochstehendes Gaszuführungsrohr aus einer ebenfalls waagerecht angeordneten, ebenen Rohrstützplatte durch den Flaschenhals von unten nach oben eingeführt werden kann. Die Gaszuführrohre sind ebenso in einer Reihe vertikal auf der waagerechten Rohrstützplatte angeordnet wie die Reihe der zu beschichtenden Flaschen. Für den Betrieb muss die Trägerplatte aus einer ersten waagerechten Position in eine zweite waagerechte Position verfahren werden. In der zweiten Position wird die Rohrstützplatte vertikal in Verbindung zu der Trägerplatte gebracht, wobei die aus diesen beiden Platten bestehende Einheit nach ihrem Zusammenfahren weiter in vertikaler Richtung in eine evakuierbare Behandlungskammer hinein- und nach der Behandlung herausbewegt wird.

Danach wird auch die Trägerplatte wieder horizontal zurückgefahren. Es werden besondere Einrichtungen benötigt, um die beschichteten Flaschen von der Trägerplatte zu lösen und von dieser abzustreifen. Der Platzbedarf einer solchen Beschichtungsmaschine ist infolge der waagerechten Anordnung der Trägerplatte und der Rohrstützplatte groß. Außerdem ist die Entladung aufwendig.

Ebenfalls bekannt ist eine Vorrichtung nach DE 100 10 642. Bei dieser Vorrichtung sind die Hohlkörperträgerplatte, die Rohrstützplatte und die dazu korrespondierend angeordneten Gaszuführrohre vertikal angeordnet. Dieser Lösung haftet der Nachteil an, dass eine derartige Behandlungsmaschine nur mit großem Aufwand an übliche Transportanlagen für Gefäße angeschlossen werden kann, da die normalerweise aufrecht stehend transportierten Flaschen für die Behandlung durch eine zusätzliche Vorrichtung zunächst in eine vertikale Position geschwenkt werden müssen. Ebenfalls müssen die Flaschen nach der Behandlung durch eine weitere Vorrichtung wieder in eine horizontale Position geschwenkt werden.

Ebenso bekannt ist eine Vorrichtung nach DE 199 22 873. Bei dieser Vorrichtung erfolgt die Beschichtung der Flaschen einzeln und in einem kontinuierlichen Prozess. Entsprechend erfolgen auch die Zu- und die Abfuhr der Kunststoffflaschen zum bzw. vom Beschichtungsprozess kontinuierlich. Dazu werden die Kunststoffflaschen durch eine Greif- und Haltevorrichtung von üblichen Transportvorrichtungen abgenommen und an einen drehantreibbaren Schleusenrotor übergeben. Dieser Schleusenrotor weist Schleusenkammern auf, welche dazu dienen, die zu behandelnden Flaschen in die ein Vakuum aufweisende Behandlungszone zu überführen. Innerhalb der Behandlungszone werden die Flaschen durch eine Greif- und Haltevorrichtung aus den Schleusenkammern entnommen und an eine weitere Fördervorrichtung übergeben. Dieser Fördervorrichtung transportiert die Flaschen zu den Behandlungsstationen. Nach erfolgter Behandlung der Flaschen werden diese durch den zuvor erwähnten Förderer wieder zum Schleusenrotor transportiert, wo eine weitere Greif- und Haltevorrichtung die Flaschen wieder an die Schleusenkammern übergibt. Im weiteren Fortgang des Verfahrens werden die Schleusenkammern auf Umgebungsdruck gebracht, so dass die Flaschen den Schleusenkammern wieder entnommen und an eine weitere Transportvorrichtung übergeben werden können. Vorrichtungen dieser Art bedingen einen sehr hohen mechanischen Aufwand und damit verbunden sehr hohe Anschaffungs- und Betriebskosten. Ebenfalls ist ein hoher Platzbedarf für eine solche Vorrichtung gegeben.

Der Erfindung liegt die Aufgabe zugrunde, hier Abhilfe und Verbesserung zu schaffen, so dass der mechanische Aufwand und damit verbunden die Anschaffungs- und Betriebskosten für Vorrichtungen der oben genannten Art vermindert werden.

Hierzu sieht die Erfindung vor, dass eine Vorrichtung geschaffen wird, die mehrere Flaschen gleichzeitig beschichtet. Dazu ist vorgesehen, die Flaschen durch eine geeignete Vorrichtung von der Transportvorrichtung abzunehmen und zu magazinieren. Durch eine Packvorrichtung werden die Flaschen auf einen Transportwagen umgesetzt. Dieser Transportwagen verfährt anschließend horizontal in eine Bearbeitungsposition, in welcher ein Plasma-Behandlungskopf auf die Flaschen aufgesetzt wird. Nach der Behandlung verfährt der Transportwagen in eine weitere horizontale Position. In dieser Position werden die Flaschen durch eine weitere geeignete Vorrichtung vom Transportwagen abgenommen und dem Abtransport zugeführt.
Weitere Merkmale ergeben sich aus den Unteransprüchen.
Die Vorteile der Erfindung liegen in dem verringerten mechanischen Aufwand und den folglich reduzierten Anschaffungs- und Betriebskosten.

Im Nachfolgenden wird die Erfindung anhand eines Ausführungsbeispiels näher erläutert.

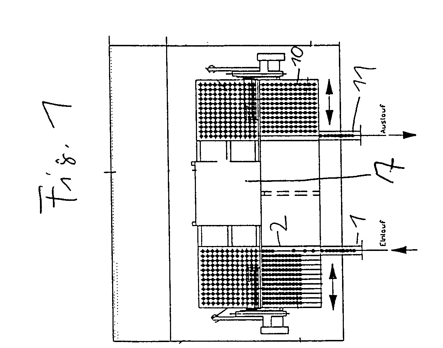

- Fig. 1: zeigt die Draufsicht einer Gesamtanlage,

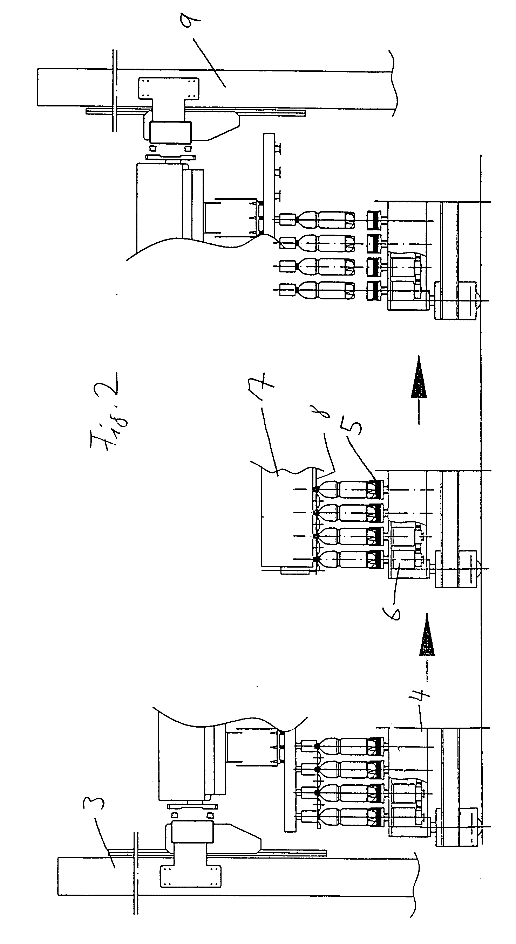

- Fig. 2: zeigt eine Vorderansicht der wichtigsten Komponenten einer solchen Gesamtanlage und

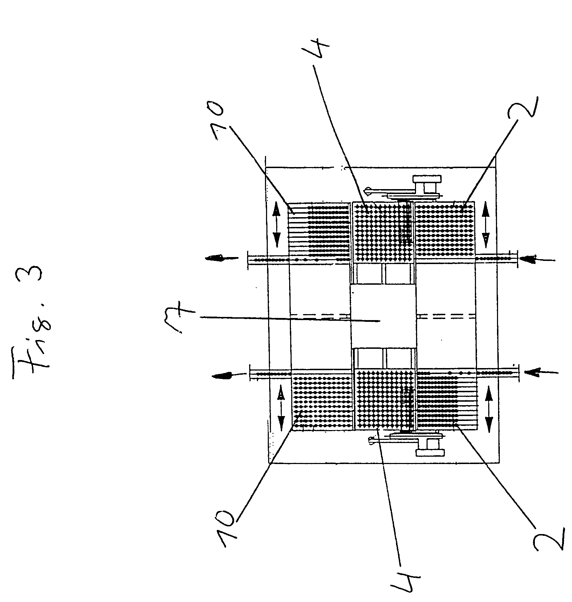

- Fig. 3: zeigt eine weitere Ausführung der Erfindung mit zwei Transportwagen

Anhand einer bekannten Transportvorrichtung für Flaschen 1, zum Beispiel einem Lufttransporteur, werden die Flaschen einem Einlaufmagazin 2 zugeführt. Dieses Einlaufmagazin besitzt eine definierte Anzahl von Aufnahmeplätzen für Flaschen. Sind alle Plätze belegt, so werden alle im Magazin bereitgestellten Flaschen 1 durch eine geeignete Entnahmevorrichtung 3, zum Beispiel einem bekannten Packer, entnommen und auf einen Transportwagen 4 gesetzt.

Dieser Transportwagen 4 setzt sich aus einem Unterteil und einem Oberteil zusammen. Das Unterteil des Transportwagens dient zum Verfahren des Transportwagens in horizontaler Richtung. Um unterschiedliche Flaschenhöhen verarbeiten zu können, ist das Oberteil, zum Beispiel durch Spindelhubgetriebe, höhenverstellbar ausgeführt. Auf dem Oberteil ist für jede zu übernehmende Flasche ein fest definierter Standort vorgesehen. Dieser besteht aus einer gleichzeitig als Resonator dienenden und mit einem Erdungskabel versehenen Aufnahme 5 und einem nicht näher dargestellten Höhenausgleicher, welcher dazu dient Schwankungen der Flaschenhöhen auszugleichen. Aufnahme 5 und Höhenausgleicher sind so ausgeführt, dass sie um ihre Hochachse drehbar sind. Um die Aufnahmen in Rotation versetzten zu können, sind Flaschendrehantriebe 6 vorgesehen. Nach dem der Transportwagen beladen ist, verfährt dieser in eine zweite horizontale Position. In dieser Position wird ein Plasma-Behandlungskopf 7 auf die zu behandelnden Flaschen abgesenkt. Gleichzeitig mit dem Plasma-Behandlungskopf 7 wird ein Niederhalter 8 auf die Flaschen aufgesetzt, welcher in Zusammenwirkung mit dem Höhenausgleicher so auf die Flaschen einwirkt, dass alle Flaschenmündungen für die nachfolgende Behandlung auf der selben Höhe stehen und abgedichtet anpressbar sind.

Im Anschluss an die Behandlung wird der Plasma-Behandlungskopf 7 angehoben und in seine Ausgangsposition verfahren. Anschließend verfährt der Transportwagen in eine weitere horizontale Position. In dieser Position werden die Flaschen durch eine geeignete Entnahmevorrichtung 9 aus den Aufnahmen 5 des Transportwagens 4 entnommen und an ein Auslaufmagazin 10 übergeben, von wo aus die Flaschen an eine weitere Transportvorrichtung 11 weitergeleitet werden. Nach dem Entladen verfährt der Transportwagen 4 wieder in die Ausgangsposition; der Ablauf kann erneut beginnen.

Eine weitere sinnvolle Variante der Erfindung sieht vor, dass der Plasma-Behandlungskopf 7 durch die Verwendung von zusätzlichen Bauteilen, zum Beispiel Seiten-, Vor- und Rückwänden, so ausgeführt ist, dass er nach dem Aufsetzen auf die Flaschen gemeinsam mit dem Oberteil des Transportwagens 4 eine luftdichte Kammer bildet. Diese Kammer ermöglicht es, die Prozessparameter wie zum Beispiel Druck, Temperatur und Zusammensetzung des Prozessgases für die Plasmabeschichtung zu definieren. Zusätzlich ermöglicht diese Kammer die Abschirmung der Umgebung vor eventuell schädlichen elektromagnetischen Einflüssen.

Eine andere Ausgestaltung der Erfindung sieht vor, dass der Transportwagen 4 doppelt vorhanden ist. Je ein Transportwagen befindet sich links und rechts des Plasma-Behandlungskopfes 7. Die Transportwagen können abwechselnd von ihrer jeweiligen Beladeposition in die Behandlungsposition unter dem Plasma-Behandlungskopf und wieder zurück verfahren werden.

Bei dieser Ausführung werden ebenfalls zwei Einlaufmagazine 2 vorgesehen. Diese sind so angeordnet, dass sie den Beladepositionen der Transportwagen zugeordnet sind. Ebenfalls sind zwei Auslaufmagazine10 vorgesehen, welche sich bei dieser Ausgestaltung hinter den Beladepositionen der Transportwagen befinden. Sowohl Einlauf-, als auch Auslaufmagazine können durch Transportvorrichtungen mit einander verbunden werden.
Der Behandlungsprozess stellt sich bei dieser Variante wie folgt dar.
Durch die Anbindung an einen Flaschentransporteur werden die Einlaufmagazine mit Flaschen versorgt. Ist ein Einlaufmagazin mit Flaschen gefüllt, so werden die Flaschen durch die Entnahmevorrichtung 3,9 aus dem Magazin entnommen und auf die Aufnahmen 5 des zugeordneten Transportwagens 4 gestellt. Befindet sich der andere Transportwagen zu diesem Zeitpunkt nicht in der Behandlungsposition, so verfährt der zuvor beladene Transportwagen in diese. Im Anschluss an die Behandlung verfährt der Transportwagen wieder in die Beladeposition. Gleichzeitig nimmt der zwischenzeitlich mit Flaschen beladene zweite Transportwagen die Behandlungsposition ein. Ist der erste Transportwagen in seiner Beladeposition angekommen, entnimmt die dortige Entnahmevorrichtung 3,9 die Flaschen aus dem Aufnahmen und übergibt diese an das zugehörige Auslaufmagazin. Anschließend kann der Transportwagen erneut beladen werden. Während des Ent- und Beladens des ersten Transportwagens werden die Flaschen des zweiten Transportwagens behandelt. Diese Vorgehensweise gestattet bei nur geringfügig höherem Aufwand eine deutliche Steigerung der Anlagenleistung.

Eine weitere sinnvolle Ausgestaltung der Erfindung sieht vor, dass der Plasma-Behandlungskopf 7 verfahrbar ausgeführt ist. Bei dieser Ausführung können die beiden Transportwagen 4 durch ortsfeste Aufnahmegestelle ersetzt werden. Diese Aufnahmegestelle sind sinnvollerweise höhenverstellbar und ebenfalls mit den oben beschriebenen Aufnahmen 5, Höhenausgleichern und den Flaschendrehantrieben 6 ausgestattet. Wie oben beschrieben, beladen die Entnahmevorrichtungen 3 die Aufnahmegestelle mit den zu beschichtenden Flaschen. Anschließend wird der Plasma-Behandlungskopf derart verfahren, dass er mit einem der beiden Aufnahmegestelle korrespondiert. Nach der Beschichtung dieser Flaschen, wird der Plasma-Behandlungskopf in eine Position verfahren, in der er mit dem anderen Aufnahmegestell korrespondiert. Bei dieser Ausführung kann das Be- und Entladen der Aufnahmegestelle unabhängig von der im Wechsel erfolgenden Beschichtung erfolgen, sodass Wartezeiten eingespart und höhere Ausbringungszahlen erreicht werden können.

## Patentansprüche

1. Vorrichtung zur gleichzeitigen Plasma-Beschichtung der inneren Oberflächen mehrerer Behälter, z.B. PET-Flaschen, **dadurch gekennzeichnet, dass** die zu beschichtenden Flaschen von einer Beladevorrichtung (3) aus einem Einlaufmagazin (2) entnommen und auf einen höhenverstellbaren, mit Flaschendrehantrieben (6) und Höhenausgleichern ausgestatteten Transportwagen (4) abgesetzt werden, und dass dieser Transportwagen (4) die Behälter in eine Behandlungsposition transportiert und diese wiederum nach der Behandlung in eine weitere Position transportiert, in welcher die Behälter durch eine Entladevorrichtung (9) von dem Transportwagen (4) entnommen und auf ein Auslaufmagazin (10) abgesetzt werden.

2. Vorrichtung nach Anspruch 1, **dadurch gekennzeichnet, dass** Transportwagen (4) und Plasma-Behandlungskopf (7) derart gestaltet sind, dass diese in der Behandlungsposition eine gegen die umgebende Atmosphäre abgeschlossene, evakuierbare Kammer bilden.

3. Vorrichtung nach Anspruch 1 oder 2, **dadurch gekennzeichnet, dass** Transportwagen (4), Einlaufmagazin (2) und Auslaufmagazin (10) doppelt vorhanden sind, und dass die Transportwagen (4) im Wechsel in die Behandlungsposition verfahrbar sind.

4. Vorrichtung nach einem der Ansprüche 1 - 3, **dadurch gekennzeichnet, dass** der Plasma-Behandlungskopf (7) verfahrbar ausgeführt ist.

5. Vorrichtung nach einem der Ansprüche 1 - 4, **dadurch gekennzeichnet, dass** der Plasma-Behandlungskopf (7) mit einem Flaschenniederhalter (8) versehen ist.

6. Vorrichtung nach Anspruch 2, **dadurch gekennzeichnet, dass** die evakuierbare Kammer so ausgeführt ist, dass die Umgebung vor elektromagnetischen Einflüssen abgeschirmt wird.
